(19) Europäisches Patentamt
European Patent Office
Office européen des brevets

(11) Publication number: **0 225 505 B1**

(12) **EUROPEAN PATENT SPECIFICATION**

(45) Date of publication of patent specification: **27.12.91**  (51) Int. Cl.5: **B26F 3/00, H05K 3/00**

(21) Application number: **86115735.2**

(22) Date of filing: **12.11.86**

(54) Film peeling apparatus.

(30) Priority: **12.11.85 JP 253434/85**
**27.11.85 JP 266490/85**

(43) Date of publication of application:
**16.06.87 Bulletin 87/25**

(45) Publication of the grant of the patent:
**27.12.91 Bulletin 91/52**

(84) Designated Contracting States:
**CH DE FR GB IT LI SE**

(56) References cited:
**EP-A- 0 142 880       DE-A- 2 634 413**
**DE-A- 2 645 737       DE-A- 2 751 862**
**DE-A- 2 751 862       DE-A- 3 402 009**
**DE-B- 1 231 261       DE-B- 1 232 875**
**JP-A-58 091 782       US-A- 3 669 445**

**PATENT ABSTRACTS OF JAPAN, vol. 9, no. 6**
**(P-326)[1729], 11th January 1985; & JP-A-59**
**154 447 (HITACHI KASEI KOGYO K.K.)**
**03-09-1984**

(73) Proprietor: **SOMAR CORPORATION**
**11-2, Ginza 4-chome Chuo-ku**
**Tokyo 104(JP)**

(72) Inventor: **Sumi, Shigeo**
**8-11, Ayase**
**Hasuda-shi Saitama(JP)**

(74) Representative: **Boeters, Hans Dietrich, Dr. et al**
**Bereiteranger 15**
**W-8000 München 90(DE)**

## Description

This invention relates to a film peeling apparatus for peeling off and discharging a film stuck on a board such as of a printed circuit board.

Printed circuit boards for use in electronic equipment such as computers are provided with a predetermined copper wiring pattern formed on one or both sides of insulating boards. A printed circuit board of that sort is manufactured substantially by the following steps: laminating a combination of a photosensitive resin layer (photoresist) and a translucent resin film (protective film) for protecting the photosensitive resin layer onto a conductive layer disposed on an insulating substrate through thermocompression bonding, superposing a film having a wiring pattern, exposing the photosensitive resin layer for a fixed period of time to light inciding through the film having the wiring pattern and the translucent resin film, developing the thus exposed photosensitive resin layer after peeling off the translucent resin film to form an etching mask pattern, removing the unnecessary portions of the conductive layer by etching, and, finally, removing the remaining photosensitive resin layer.

As mentioned before, during the aforementioned steps of manufacturing a printed circuit board the translucent resin film must be peeled off when the photosensitive resin layer is to be developed after having been exposed to light. To perform this task mechanically, devices have already been constructed employing an adhesive tape which is stuck to the translucent resin film for peeling off (see e.g. JP-A-58 091 782). Other devices are known which employ suction means to strip a protective layer from a base.

In DE-A1-27 51 862 an apparatus is disclosed which has two consecutive rubbing devices followed by a stripping unit to peel off a protective resin film in the production of printed circuit boards.

Still, none of the conventional apparatus was effective in reliably peeling off a protective film where this rather firmly sticks to its underground, particularly where this underground tends to warp and wave.

Accordingly, the invention as claimed is intended to solve the problem of more reliably peeling off a protective film such as a translucent resin film from a base as e.g. in the manufacture of a printed circuit board.

The respective film lifting means lifting a part of an end portion of the film has proved to be very effective in initiating peeling. Corresponding lifting means in the form of e.g. a hand tool comprising a vibratory scraper have been known heretofore from e.g. DE-A1-34 02 009 for removing paint, wall paper, tar paper and plaster. Employment of such lifting means has shown to be very effective to initiate peeling of a film stuck on a base such as that one of a printed circuit board provided that the end of the film is hit correctly and that the board is prevented from yielding.

The dependent claims describe additional means or measures which assist in achieving the aforementioned aim.

In the following a preferred embodiment of the invention in the form of a film peeling apparatus for peeling a protective film from a base in the production of printed circuit boards is described taking reference to the accompanying drawings. In these

Fig. 1
a schematic side elevational view showing a film peeling apparatus in accordance with the present invention,

Fig. 2
is a side elevational view showing essential parts of the present invention in more detail,

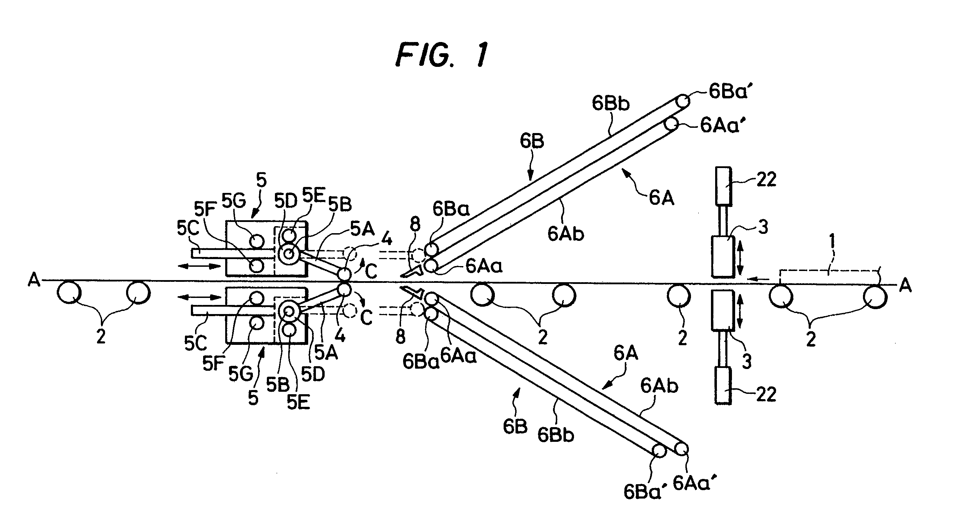

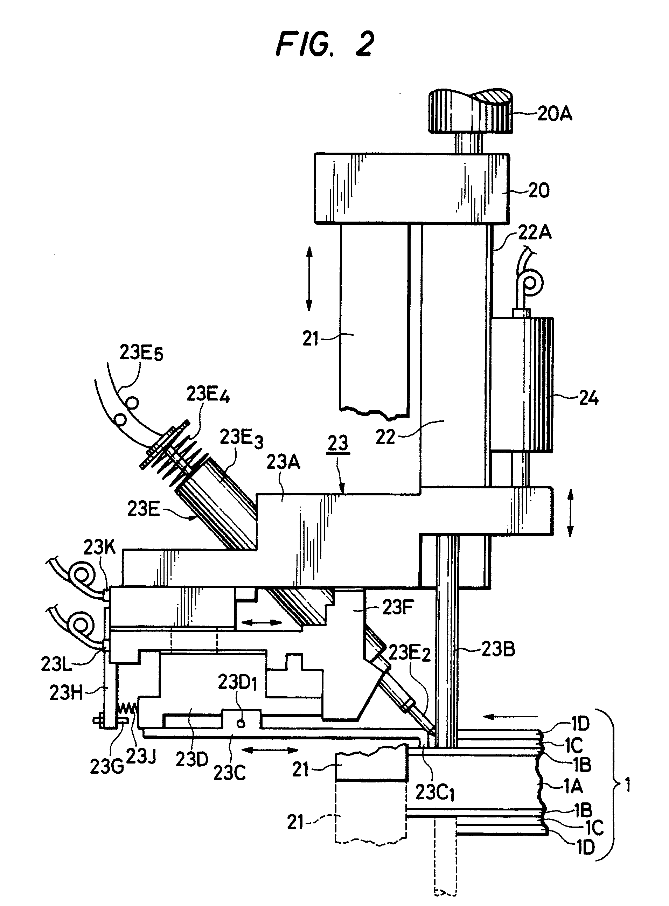

Fig. 3(A) and 3(B)
are side views showing film lifting units as employed in the embodiment shown in Figs. 1 and 2,

Fig. 4
is a plan view showing the positional relationship between parts shown in Fig. 2,

Fig. 5
is a perspective view showing a film end detecting mechanism and stops in accordance with the aforementioned embodiment;

Fig. 6
is a schematic cross-sectional view showing a film peeling and discharging mechanism of the apparatus of Fig. 1 in more detail and

Figs. 7 and 8
are a schematic fragmentary perspective view and respectively, a side sectional view along line B-B showing part of the film peeling and discharging mechanism incl. a film peeling plate in still more detail.

As shown in Fig. 1, a mechanism for conveying a board 1 in the form of a base for a printed circuit board in a film peeling apparatus of the present invention comprises conveying means in the form of conveyor rollers 2 for carrying the board 1. A film lifting mechanism 3, adhesive members 4 mounted on movable arms 5A of a film raising mechanism (film raising means) 5, and a film peeling plate 8 are installed along the conveyance path of the conveying means on both sides thereof.

As shown in Fig. 2, the board 1 is formed of conductive layers 1B of copper stuck to both sides (or, alternatively, only one side) of an insulating substrate 1A. Laminated bodies, each consisting of a photosensitive resin layer 1C and a protective film in the form of a translucent resin film 1D, are stuck on the conductive layers 1B of the printed circuit board 1 through thermocompression bonding. The photosensitive resin layers 1C have already previously been exposed to a light pattern to form a mask for obtaining a desired wiring pattern.

The conveyor rollers 2 carry the board 1 in the direction of the arrow shown at the beginning of the conveyance path A-A of Fig. 1.

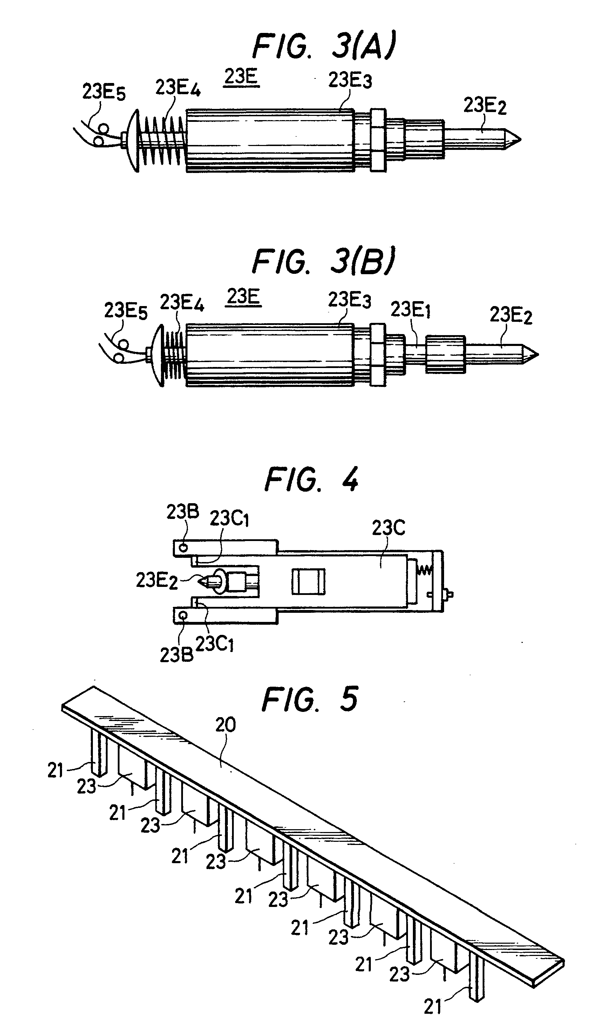

As shown in Fig. 5, in the film lifting mechanism 3, a plurality of stops 21 for stopping the board 1 at a predetermined position are provided on a support frame 20 which is slidably mounted in the film peeling apparatus.

As shown in Figs. 2, a plurality of film lifting unit support frames 22 are provided on the support frame 20. Each of the support frames 22 has a guide rail 22A along which a film lifting unit 23 is moved up and down. The support frame 20 is adapted to be moved itself by an air cylinder 20A. The film lifting unit 23 is slidably mounted by a support frame 23A on the guide rail 22A. Each support frame 23A is moved by an air cylinder 24 to be close to or remote from the board 1.

On the support frame 23A there is mounted a pressing member 23B which serves to press the board 1 that has been stopped by the stops 21 to eliminate any curvature or warpage of the board. On the support frame 23A, there are slidably mounted a film end detecting member support frame 23D supporting a film end detecting member 23C, and a film lifting member support frame 23F.

The film lifting member support frame 23F is slidably mounted on the film end detecting member support frame 23D. A film lifting member (film lifting means) 23E is fixed to the distal end of the support frame 23F at a predetermined slant angle. A screw 23G for adjustment or the stroke of movement of the film lifting member 23E is provided at the rear end of the support frame 23F on an arm 23H. A spring 23J is provided for urging the film lifting member support frame 23F rearwardly. The stroke adjustment screw 23G permits to adjust the distance between the film lifting member 23E and the end of the film 1D to be peeled off.

An end of the film end detecting member 23C is bent downwardly and is bifurcated to define therein a U-shaped space (Fig. 4). The film end detecting member 23C is tiltably mounted by a pin 23D1 to the film end detecting member support frame 23D.

The film lifting member 23E comprises a vibrator as described in the following: Fig. 3A shows the film lifting member 23E in a condition where an electric power is supplied to it and Fig. 3B shows the film lifting member 23E where no electric power is supplied to it. A needle-like member 23E2 is provided to a movable shaft 23E1 of the film lifting member 23E. When no electric power is supplied to an electromagnetic coil 23E3 of the film lifting member as shown in Fig. 3A, the needle-like member 23E2 is retracted rearwardly by a spring 23E4. When electric power is supplied through an electric source cord 23E5 to the electromagnetic coil 23E3 as shown in Fig. 3B, the shaft 23E1 is projected to project the needle-like member 23E2, at the same time vibrating it.

As shown in Fig. 4, in non-operation, the distal end of the film end detecting member 23C and the distal end of the film lifting member 23E are located at a retracted position from the pressing members 23B. During operation, these ends are projected somewhat towards the position of the pressing members 23B.

Of course the construction of the film lifting means is not limited the above-described film lifting member 23E including an electric vibrator but a variety or other vibrators such as a supersonic vibrator that vibrates by supersonic waves, a mechanical vibrator that vibrates by translating a rotational motion into a linear motion or a fluid type vibrator that vibrates according to a fluid pressure may also be used.

In the following, the operation of the film lifting unit 23 so far described will briefly be explained:

In Fig. 2, when the support frame 20 is moved toward the conveyance path by the air cylinder 20A, the travelling board 1 is stopped by the stops 21. Subsequently, the support frame 23A is moved toward the conveyance path by the air cylinder 24, thereby applying a pressure to the board leading end. Thus, any warpage or curvature of the board 1 is eliminated. Under this condition, the support frame 23D is moved rightwardly by an air cylinder 23K, so that the film end detecting member 23C is brought into contact with the photosensitive resin layer 1C or the translucent resin film 1D. Under this condition, the support frame 23F is moved rightwardly by an air cylinder 23L, the needle-like member 23E2 of the film lifting unit 23E then being driven. Accordingly, vibrations are applied to the film 1D so that it will be lifted away from the photosensitive resin layer 1C.

As shown in Fig. 1, the adhesive members 4 are attached to moveable arms 5A of the film raising mechanism 5. Each arm 5A is rotatable about a shaft 5B, so that its adhesive member 4 is pressed against the lifted end portion of the film 1D. The shaft 5B is supported by a support rod or rack 5C and, when the adhesive member 4 is in contact with the outward face of the lifted end portion of the film 1D, the arm 5A is rotated in the direction of an arrow C by gears 5D, 5E. By rightward moving of the rod or rack 5C through gears 5F, 5G, the thus raised end portion of the film 1D is carried to an inlet of the film peeling and discharging mechanism 6. There the film 1D is clamped between rollers 6Aa and 6Ba. Thereafter, the arm 5A is retracted leftward, thereby separating its adhesive member 4 from the film 1D.

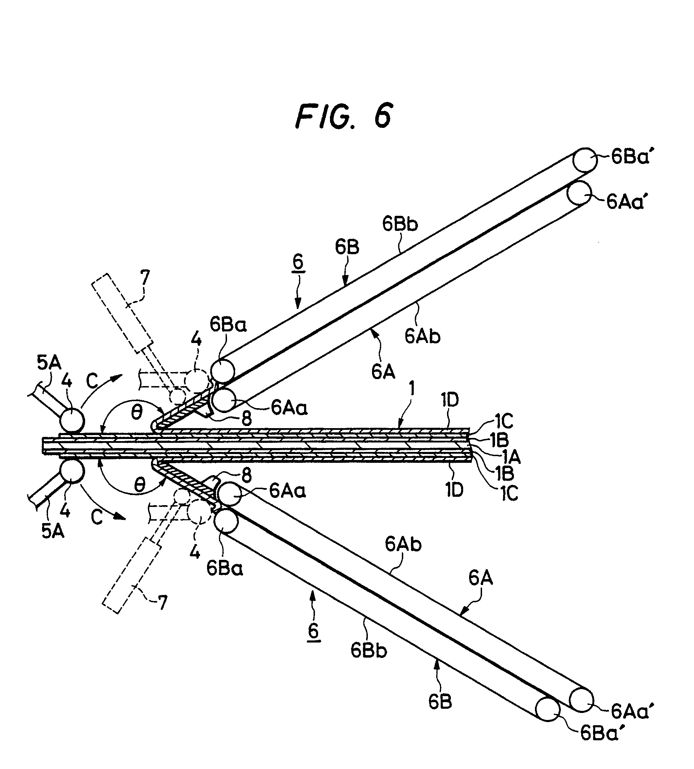

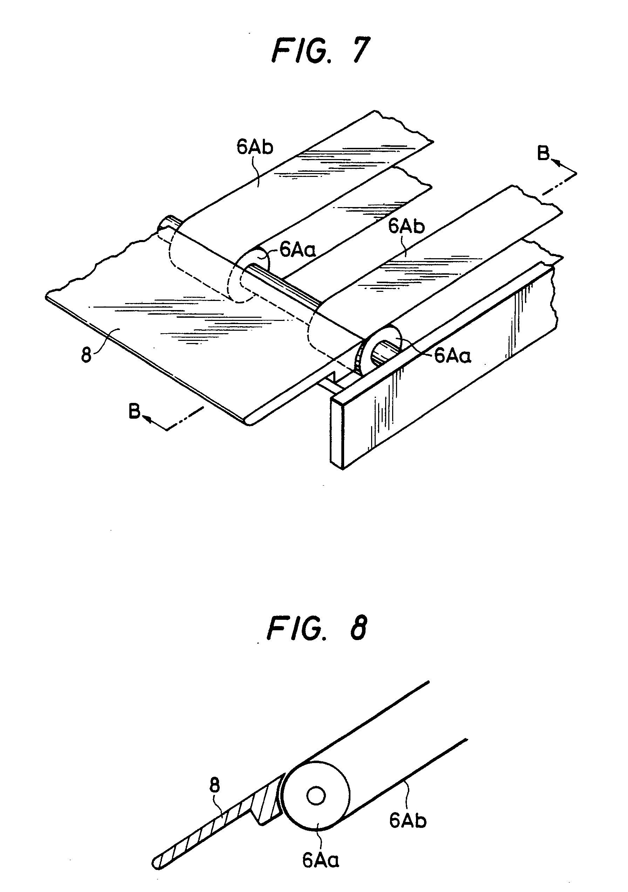

In order to ensure the separation of the adhesive member 4 from the film 1D, as shown in Fig. 6, a film end pressing mechanism 7 may be used as shown by dotted lines in Fig. 6.

As shown in Figs. 6 to 8, the film peeling plate 8 is arranged in a box member of the apparatus, so that it is aligned with belt conveyors 6A and 6B of the film peeling and discharging mechanism 6.

In order to prevent displacement of the peeling position during the peeling action due to the local application of the peeling stress, and to prevent damage of the film 1D and the underlying photosensitive resin layer 1C, the film peeling plate 8 is adjustable to set the peeling angle of the film 1D. That is, the peeling angle $\theta$ defined between the raised film 1D and the board 1 can be set. Further, the front end of the film peeling plate 8 is movable close to or away from the board 1.

The front end of the film peeling plate 8 has an arcuate shape defined by a small radius of curvature in cross-section. For example, the curvature radius is less than 3 mm. The film peeling plate 8 stabilizes the peeling position and distributes the stresses in the film 1D as well as in the photosensitive layer 1C.

As mentioned before, the peeling and discharging mechanism 6 is further composed of belt conveyors 6A and 6B. The belt conveyor 6A, as shown in Figs. 1 and 6, has a plurality of paired rollers 6Aa and 6Aa' and belts 6Ab entrained between the rollers 6Aa and 6Aa'. In the same manner, the belt conveyor 6B is composed of a plurality of paired rollers 6Ba and 6Ba' and belts 6Bb entrained therebetween.

The belt conveyor 6B may be rotatable about the rollers 6Ba' by a drive means such as an air cylinder to be brought into contact with the belts 6Ab of the other belt conveyor 6A. Thus, the end portion of the film 1D brought to the inlet of the peeling and discharging mechanism 6 can be clamped and moved for discharge without fail.

That is, each film 1D delivered by the film raising mechanism 5 and guided by the film peeling plate 8 is clamped between the belt conveyors 6A and 6B. Then, by driving the respective paired rollers 6Aa, 6Aa' and 6Ba, 6Ba', the films 1D are completely peeled off and discharged one after another.

When the films 1D have been peeled off the boards 1 are delivered by further conveyance rollers 2 to a developing section (not shown) where the photosensitive resin layer 1C is to be developed.

In the foregoing embodiment, the film lifting mechanism 3 is disposed upstream of the film peeling plate 8. It is, however, possible as well to dispose the mechanism 3 between the film raising mechanism 5 and the film peeling plate 8.

The foregoing embodiment of the invention has been described in connection with the peeling of a translucent resin film from a base as used in the production of printed circuit boards. However, the invention may also be used for other peeling purposes as, for example, the peeling of a protective film from decorative plates of building material.

The film lifting means could as well comprise pressing members, brushes and the like. Also, instead of the adhesive members 4, fluid injection means could be used for injecting a fluid into the gap existing under the lifted film portion.

## Claims

1. A film peeling apparatus for peeling off and discharging a film (1D) stuck on a board (1), comprising:

   conveying means (2) for carrying the board (1) through said apparatus,

   board correcting means (23B) for applying a pressure to an end portion of said board (1), thereby correcting a warpage and/or curvature of the board,

   film end detecting means (23C) for detecting an end of the film (1D) under the condition that the pressure is applied to the end portion of the board (1) by said board correcting means (23B),

   film lifting means (23E) for lifting a part of the film (1D) from its end off the board (1) up to a predetermined distance from said end as detected by said film end detecting means (23C), and

   film raising means (5) for raising that lifted part of said film from the board (1) and feeding it into a film peeling and discharging mechanism (6) receiving said lifted part of said film and drawing the remaining film following said part off said board (1).

2. The film peeling apparatus of claim 1, further comprising stop means (21) for stopping said board (1) at a predetermined position, said board correcting means (23B) being operative when said board has been stopped at this predetermined position.

3. The film peeling apparatus of anyone of the preceding claims, wherein the location of engagement of said film lifting means (23E) is substantially congruent with the location of engagement of said board correcting means (23B).

## Revendications

1. Appareil d'enlèvement de film destiné à enlever et à évacuer un film (1D) collé sur une carte (1), comprenant :

   des moyens de transport (2) servant à transporter la carte (1) à travers l'appareil,

   des moyens (23B) de correction de la carte destinés à appliquer une pression sur une partie d'extrémité de ladite carte (1), pour corriger ainsi le gauchissement et/ou la courbure de la carte,

   des moyens (23C) de détection de l'extrémité du film destinés à détecter une extrémité du film (1D) dans la situation où la pression est appliquée à la portion d'extrémité de la carte (1) par lesdits moyens (23B) de correction de la carte,

   des moyens (23E) de décollement du film destinés à décoller une partie du film (1D) de son extrémité de la carte (1) jusqu'à une distance prédéterminée de ladite extrémité, détectée par lesdits moyens (23C) de détection de l'extrémité du film, et

   des moyens (5) de soulèvement du film, servant à soulever la partie décollée dudit film de la carte (1) et à l'introduire dans un mécanisme (6) d'enlèvement et d'évacuation, qui reçoit ladite partie décollée de ladite film et arrache de ladite carte (1) le film restant qui fait suite à ladite partie.

2. Appareil d'enlèvement de film selon la revendication 1, comprenant en outre des moyens de butée (21) servant à arrêter ladite carte (1) dans une position prédéterminée, lesdits moyens (23B) de correction de la carte intervenant lorsque ladite carte a été arrêtée à cette position prédéterminée.

3. Appareil d'enlèvement de film selon une quelconque des revendications précédentes, dans lequel la position d'attaque desdits moyens de décollement (23E) sont sensiblement en coïncidence avec le point d'attaque desdits moyens (23B) de correction de la carte.

## Patentansprüche

1. Filmabschälvorrichtung zum Abschälen und Abführen eines einer Platte (1) anhaftenden Films (1D) mit:

   Fördermitteln (2) zum Fördern der Platte (1) durch die Vorrichtung,

   Plattenkorrekturmitteln (23B) zum Aufbringen eines Drucks auf einen Endabschnitt der Platte (1) zum Korrigieren einer Verwerfung und/oder Krümmung der Platte,

   Filmendermittlungsmitteln (23C) zum Ermitteln eines Endes des Films (1D) unter der Bedingung, daß der Druck mittels der Plattenkorrekturmittel (23B) auf den Endabschnitt der Platte (1) aufgebracht ist,

   Filmanhebemitteln (23E) zum Anheben eines Teils des Films (1D) von seinem Ende her von der Platte (1) bis zu einer vorbestimmten Entfernung von dem Ende, wie es von den Filmendermittlungsmitteln (23C) festgestellt wird, und

   Filmabhebemitteln (5) zum Abheben des angehobenen Teils des Films von der Platte (1) und seinem Zuführen zu einem Filmabschäl- und -abführmechanismus (6), der den angehobenen Teil des Films empfängt und den auf diesen Teil folgenden restlichen Film von der Platte (1) abzieht.

2. Filmabschälvorrichtung nach Anspruch 1, des weiteren enthaltend Anhaltemittel (21) zum Anhalten der Platte (1) in einer vorbestimmten Position, wobei die Plattenkorrekturmittel (23B) aktiv sind, wenn die Platte in dieser vorbestimmten Position angehalten worden ist.

3. Filmabschälvorrichtung nach einem der vorhergehenden Ansprüche, worin der Ort des Eingriffs der Filmanhebemittel (23E) im wesentlichen mit dem Ort des Eingriffs der Plattenkorrekturmittel (23B) zusammenfällt.

FIG. 1

# FIG. 2

## FIG. 3(A)

23E5  23E4  23E  23E3  23E2

## FIG. 3(B)

23E5  23E4  23E  23E3  23E1  23E2

## FIG. 4

23B  23C1  23C

23E2

23B  23C1

## FIG. 5

20

21  23  21  23  21  23  21  23  21  23  21  23  21

## FIG. 6

## FIG. 7

6Ab

6Aa

6Ab

6Aa

8

B

B

## FIG. 8

8

6Ab

6Aa